# EUROPEAN PATENT APPLICATION

(11) **EP 4 213 224 A1**
(43) Date of publication of application: **19.07.2023**
(21) Application number: 22151583.6
(22) Date of filing: 14.01.2022
(51) Int. Cl.: H01L 31/0687, H01L 31/0693, H01L 31/078, H01L 31/0304

(54) **MULTIJUNCTION SOLAR CELLS WITH SHIFTED JUNCTION**

(71) Applicant: SolAero Technologies Corp., a corporation of the state of Delaware, Albuquerque, NM 87123 (US)
(72) Inventor: DERKACS, Daniel, ALBUQUERQUE, 87111 (US)
(74) Representative: de Rooij, Mathieu Julien

(57) **Abstract**

A multijunction solar cell including an upper first solar subcell having a first band gap and positioned for receiving an incoming light beam; a second solar subcell disposed below and adjacent to and lattice matched with said upper first solar subcell, and having a second band gap smaller than said first band gap; wherein the ratio of the thickness of the emitter layer to the thickness of the base layer in at least one of the solar subcells is between 5:1 and 1:1.

## Description

### BACKGROUND OF THE DISCLOSURE

### Field of the Disclosure

The present disclosure relates to solar cells and the fabrication of solar cells, and more particularly to the design and specification of lattice matched multijunction solar cells adapted for space missions.

### Description of the Related Art

Solar power from photovoltaic cells, also called solar cells, has been predominantly provided by silicon semiconductor technology. In the past several years, however, high-volume manufacturing of III-V compound semiconductor multijunction solar cells for space applications has accelerated the development of such technology. Compared to silicon, III-V compound semiconductor multijunction devices have greater energy conversion efficiencies and generally more radiation resistance, although they tend to be more complex to properly specify and manufacture. Typical commercial III-V compound semiconductor multijunction solar cells have energy efficiencies that exceed 29.5% under one sun, air mass 0 (AM0) illumination, whereas even the most efficient silicon technologies generally reach only about 18% efficiency under comparable conditions. The higher conversion efficiency of III-V compound semiconductor solar cells compared to silicon solar cells is in part based on the ability to achieve spectral splitting of the incident radiation through the use of a plurality of photovoltaic regions with different band gap energies, and accumulating the current from each of the regions.

In satellite and other space related applications, the size, mass and cost of a satellite power system are dependent on the power and energy conversion efficiency of the solar cells used. Putting it another way, the size of the payload and the availability of on-board services are proportional to the amount of power provided. Thus, as payloads use increasing amounts of power as they become more sophisticated, and missions and applications anticipated for five, ten, twenty or more years, the power-to-weight ratio and lifetime efficiency of a solar cell becomes increasingly more important, and there is increasing interest not only the amount of power provided at initial deployment, but over the entire service life of the satellite system, or in terms of a design specification, the amount of power provided at the "end of life" (EOL) which is affected by the radiation exposure of the solar cell over time in a space environment.

### SUMMARY OF THE DISCLOSURE

### Objects of the Disclosure

It is an object of the present disclosure to provide increased photoconversion efficiency in a multijunction solar cell for space applications by implementing a shift in the location of the junction in one or more solar subcells in the solar cell.

It is another object of the present disclosure to provide increased photoconversion efficiency in a multijunction solar cell for space applications by specifying the width and the location of the depletion region in one or more solar subcells in the solar cell.

It is another object of the present disclosure to provide increased photoconversion efficiency in a multijunction solar cell for space applications by adjusting the doping in the base and emitter layers in one or more solar subcells in the solar cell which will define the location of the junction and the depletion region in that subcell.

It is another object of the present disclosure to provide increased photoconversion efficiency in a multijunction solar cell for space applications by defining the ratio of the thickness of the emitter and base layers in one or more subcells in the solar cell.

It is another object of the present disclosure to provide increased photoconversion efficiency in a multijunction solar cell for space applications by shifting the location of the junction in one or more solar subcells in the solar cell to a depth below the surface of the emitter which is substantially below the level which is customary in standard commercial solar cells.

It is another object of the present disclosure to optimize the efficiency of a multijunction solar cell for operation in a space radiation environment over an extended period of time, often referred to as the "end of life".

It is another object of the present disclosure to provide a multijunction solar cell in which the efficiency is optimized for operation in a 1200 km LEO satellite orbit;

It is another object of the present disclosure to increase the collection probability in a multijunction solar cell by a radiation environment at the end-of-life.

Some implementations of the present disclosure may incorporate or implement fewer of the aspects and features noted in the foregoing objects.

### Features of the Disclosure

All ranges of numerical parameters set forth in this disclosure are to be understood to encompass any and all subranges or "intermediate generalizations" subsumed herein. For example, a stated range of "1.0 to 2.0 eV" for a band gap value should be considered to include any and all subranges beginning with a minimum value of 1.0 eV or more and ending with a maximum value of 2.0 eV or less, e.g., 1.0 to 2.0, or 1.3 to 1.4, or 1.5 to 1.9 eV.

Briefly, and in general terms, the present disclosure provides a multijunction solar cell comprising a multijunction solar cell comprising: an upper first solar subcell composed of InGaP and having an emitter layer of n+ conductivity type with a first band gap and a thickness in the range of 350 - 500 nm and a base layer of p conductivity type and a thickness in the range of 100 - 1000 nm; and a second solar subcell disposed adjacent to and below the upper first solar subcell composed of (In)GaAs having an emitter layer of n+ conductivity type with a second band gap less than the first band gap and a thickness in the range of 350 to 500 nm and a base layer of p conductivity type and a thickness in the range of 100 - 2500 nm.

In some embodiments, the doping in the upper first solar subcell is graded in doping in the base layer that increases from 5 x 10¹⁵ free carriers per cubic centimeter adjacent the photoelectric junction to 1 x 10¹⁸ free carriers per cubic centimeter adjacent to an adjoining layer at the rear of the base layer, and in the emitter layer having a gradation in doping that decreases from approximately 1 x 10¹⁸ free carriers per cubic centimeter in the region immediately adjacent an adjoining layer at the top of the emitter layer to 1 x 10¹⁶ free carriers per cubic centimeter in the region adjacent to the photoelectric junction.

In some embodiments, in the upper first solar subcell the ratio of the thickness of the emitter layer to the thickness of the base layer is in the range of 5:1 to 1:4, and specifically may be in the range of 2:1 to 1:2.

In some embodiments, the upper first solar subcell is between 0.3 and 0.8 microns in thickness, and the second solar subcell is between 1.5 and 3.0 microns in thickness.

In some embodiments, the second solar subcell is a heterojunction subcell with a (In)GaAs emitter layer and a InGaP base layer.

In some embodiments, in the second solar subcell the ratio of the thickness of the emitter layer to the thickness of the base layer is in the range of 1:2 to 1:5.

In some embodiments, the band gap in the depletion region of the upper first solar subcell is greater than that of the band gap in the emitter layer and the base layer of said subcell.

In some embodiments, the upper first solar subcell has a first band gap in the range of 2.0 to 2.2 eV; and the second solar subcell includes an emitter layer composed of indium gallium phosphide or aluminum indium gallium arsenide, and a base layer composed of aluminum indium gallium arsenide and having a second band gap in the range of approximately 1.55 to 1.8 eV and being lattice matched with the upper first solar subcell; wherein the emitter and base layers of the second solar subcell form a photoelectric junction.

In another aspect, the present disclosure provides a multijunction solar cell comprising: an upper first solar subcell composed of InGaP and having an emitter layer of n+ conductivity type with a first band gap and a thickness in the range of 350 - 500 nm and a base layer of p conductivity type and a thickness in the range of 100- 1000 nm; a second solar subcell disposed adjacent to and below the upper first solar subcell composed of (In)GaAs having an emitter layer of n+ conductivity type with a second band gap less than the first band gap and a thickness in the range of 350 to 500 nm and a base layer of p conductivity type and a thickness in the range of 100 - 2500 nm; and a third solar subcell disposed adjacent to and below the second solar subcell composed of (In)GaAs having an emitter layer of n+ conductivity type with a second band gap less than the first band gap and a thickness in the range of 350 to 500 nm and a base layer of p conductivity type and a thickness in the range of 100 - 2500 nm.

In another aspect, the present disclosure provides a multijunction solar cell wherein, in the upper first solar subcell the ratio of the thickness of the emitter layer to the thickness of the base layer is in the range of 5:1 to 1:4, and in the second, third, and/or lower solar subcells the ratio of the thickness of the emitter layer to the thickness of the base layer is in the range of 1:2 to 1:5.

In some embodiments, the ratio of the thickness of the emitter layer to the thickness of the base layer in the second, third, and/or lower subcells is approximately 1:2.

In another aspect, the ratio of the thickness of the emitter and base layers of the subcell are designed to maximize the collection probability after radiation exposure after a specified time period, or at the "end-of-life".

In another aspect, the ratio of the thickness of the emitter and base layers of the subcell are designed to shift the location of the junction and/or the width of the depletion region is designed to maximize the collection probability after radiation exposure after a specified time period, or at the "end-of-life".

In another aspect, the ratio of the thickness of the emitter and base layers of the subcell are designed to maximize the quantum efficiency of the subcell after radiation exposure after a specified time period, or at the "end-of-life".

Is another aspect, the location of the junction in the emitter and base layers of the subcell is designed to maximize the collection probability after radiation exposure after a specified time period, or at the "end-of-life".

In another aspect, the shift in the location of the junction and the width of the depletion region is designed to maximize the collection probability after radiation exposure after a specified time period, or at the "end-of-life".

In another aspect, the location of the junction in the emitter and base layers of the subcell is designed to maximize the quantum efficiency of the subcell after radiation exposure after a specified time period, or at the "end-of-life".

In another aspect, the doping in the emitter and base layers of the subcell is designed to maximize the collection probability after radiation exposure after a specified time period, or at the "end-of-life".

In another aspect, the doping in the emitter and base layers of the subcell are designed to shift the location and/or the width of the depletion region to maximize the collection probability after radiation exposure after a specified time period, or at the "end-of-life".

In another aspect, the doping in the emitter and base layers of the subcell is designed to maximize the quantum efficiency of the subcell after radiation exposure after a specified time period, or at the "end-of-life".

In another aspect, the present disclosure provides a multijunction solar cell wherein the position of the junction in the second and/or lower subcells is selected to optimize the current production by the subcell after exposure to a predetermined amount of radiation, i.e., at a specific "end-of-life" time period by adjusting the ratio of the thickness of the emitter layer to the thickness of the base layer in that subcell.

In another aspect, the present disclosure provides a multijunction solar cell wherein the position of the junction in the second and/or lower subcells is selected to optimize the collection probability at the junction by the subcell after exposure to a predetermined amount of radiation i.e. at a specific "end-of-life" time period by adjusting the ratio of the thickness of the emitter layer to the thickness of the base layer in that subcell.

In another aspect, the present disclosure provides a multijunction solar cell comprising: an upper first solar subcell having an emitter layer of n+ conductivity type with a first band gap and a base layer of p conductivity type with the ratio of the thickness of the emitter layer to the thickness of the base layer being in the range of 5:1 to 1:4; a second solar subcell disposed adjacent to and below the upper first solar subcell having an emitter layer of n+ conductivity type with a second band gap less than the first band gap and a base layer of p conductivity type with the ratio of the thickness of the emitter layer to the thickness of the base layer being in the range of 1:2 to 1:5; a third solar subcell disposed adjacent to and below the second solar subcell having an emitter layer of n+ conductivity type with a third band gap less than the second band gap and the ratio of the thickness of the emitter layer to the thickness of the base layer is in the range of 1:2 to 1:5.

In some embodiments, the ratio of the thickness of the emitter layer to the thickness of the base layer in the second solar subcell, and one or more of the subcells disposed below the second solar subcell, is in the range of 1:2 to 1:5.

In some embodiments, the solar cell is (i) an upright four junction solar cell and the average band gap of all four subcells is equal to or greater than 1.35 eV where the average band gap of the solar cell is the numerical average of the lowest band gap material used in each subcell; or (ii) an inverted metamorphic four or five junction solar cell.

In some embodiments, the upper first solar subcell has a band gap in the range of 2.0 to 2.15, the second solar subcell has a band gap in the range of 1.65 to 1.73 eV; and the third solar subcell has a band gap in the range of 1.15 to 1.2 eV.

In some embodiments, the solar cell further comprises a distributed Bragg reflector (DBR) layer adjacent to and disposed between the third and the fourth solar subcells and arranged so that light can enter and pass through the third solar subcell and at least a portion of which can be reflected back into the third solar subcell by the DBR layer; and is composed of a plurality of alternating layers of lattice matched materials with discontinuities in their respective indices of refraction. In examples, the difference in refractive indices between alternating layers may be maximized in order to minimize the number of periods required to achieve a given reflectivity, and the thickness and refractive index of each period determines the stop band and its limiting wavelength.

In some embodiments, the DBR layer includes a first DBR layer composed of a plurality of p type In_{z}AlₓGa_{1-x-z}As layers, and a second DBR layer disposed over the first DBR layer and composed of a plurality of p type In_{w}Al_{y}Ga_{1-y-w}As layers, where 0 < w < 1, 0 < x < 1, 0 < y < 1, 0 < z < 1 and y is greater than x.

In some embodiments, the fourth solar subcell is lattice mismatched with respect to the third solar subcell.

In some embodiments, the top subcell is composed of a base layer of (InₓGa₁₋ₓ)_{1-y}Al_{y}P where x is 0.505, and y is 0.142, corresponding to a band gap of 2.10 eV, and an emitter layer of (InₓGa₁₋ₓ)_{1-y}Al_{y}P where x is 0.505, and y is 0.107, corresponding to a band gap of 2.05 eV.

In some embodiments, the solar cell further comprises a tunnel diode disposed over the fourth subcell, an intermediate layer disposed between the third subcell and the tunnel diode wherein the intermediate layer is compositionally graded to lattice match the third solar subcell on one side and the tunnel diode on the other side and is composed of any of the As, P, N, Sb based III-V compound semiconductors subject to the constraints of having the in-plane lattice parameter greater than or equal to that of the third solar subcell and different than that of the tunnel diode, and having a band gap energy greater than that of the fourth solar subcell.

In some embodiments, the efficiency of the solar cell is optimized for an operating temperature of approximately 47° C.

In another aspect, the present disclosure provides a method of manufacturing a multijunction solar cell comprising: providing a semiconductor growth substrate; and depositing a first sequence of layers of semiconductor material forming at least a first and a second solar subcell on the growth substrate; wherein the ratio of the thickness of the emitter layer to the thickess of the base layer in at least one of the second or lower solar subcells is in the range between 1:2 and 1:5.

In some embodiments, additional layer(s) may be added or deleted in the solar cell structure without departing from the scope of the present disclosure.

Some implementations of the present disclosure may incorporate or implement fewer of the aspects and features noted in the foregoing summaries.

Additional aspects, advantages, and novel features of the present disclosure will become apparent to those skilled in the art from this disclosure, including the following detailed description as well as by practice of the disclosure. While the disclosure is described below with reference to preferred embodiments, it should be understood that the disclosure is not limited thereto. Those of ordinary skill in the art having access to the teachings herein will recognize additional applications, modifications and embodiments in other fields, which are within the scope of the disclosure as disclosed and claimed herein and with respect to which the disclosure could be of utility.

### BRIEF DESCRIPTION OF THE DRAWINGS

The present disclosure will be better and more fully appreciated by reference to the following detailed description when considered in conjunction with the accompanying drawings, wherein:
FIG. 1 is a cross-sectional view of the top and a second subcell of a multijunction solar cell after several stages of fabrication including the deposition of certain semiconductor layers on the growth substrate, according to the prior art;
FIG. 2 is a cross-sectional view of the top and a second subcell of a multijunction solar cell after several stages of fabrication including the deposition of certain semiconductor layers on the growth substrate, according to an example of the present disclosure;
FIG. 3 is a cross-sectional view of a first embodiment of the solar cell according to the present disclosure that includes one grading or metamorphic layer grown on top of the bottom subcell;
FIG. 4A is a cross-sectional view of a second embodiment of the solar cell according to the present disclosure after an initial stage of fabrication including the deposition of certain semiconductor layers on the growth substrate; and
FIG. 4B is a cross-sectional view of the solar cell of FIG. 4A after removal of the growth substrate, and with the first-grown subcell A depicted at the top of the Figure.

### DESCRIPTION OF THE PREFERRED EMBODIMENT

Details of the present invention will now be described including exemplary aspects and embodiments thereof. Referring to the drawings and the following description, like reference numbers are used to identify like or functionally similar elements, and are intended to illustrate major features of exemplary embodiments in a highly simplified diagrammatic manner. Moreover, the drawings are not intended to depict every feature of the actual embodiment nor the relative dimensions of the depicted elements, and are not drawn to scale.

The present disclosure is directed to improving the efficiency at the "end of life" of a multijunction solar cell which has been exposed to a radiation environment that is typical of certain earth orbits or other space missions. In particular, the present disclosure proposes a design methodology that is related to positioning the location and characteristics of the junction and its associated depletion region in certain of the subcells of the multijunction solar cell to optimize the collection probability in that subcell after radiation exposure, as opposed to optimization at the beginning of life.

Such design methodology is concerned with a synergistic interplay of a number of factors, including the thickness of the subcell, the ratio of the thickness of the emitter layer to the thickness of the base layer, the band gap of the deletion region compared to the band gap of the emitter and base layers, the level of doping in the emitter and base layers, and the characteristics of the subcell relative to the subcell directly above it.

Thus, in one aspect the present disclosure is directed to a method of fabricating a multijunction solar cell for deployment in space in AM0 spectra in a specific earth orbit characterized by a predetermined temperature and radiation environment comprising: providing a predetermined time and temperature range (in the range of 40° to 100° Centigrade) after initial deployment, such time being at least one year and in the range of one to twenty-five years; determining the amount of radiation experienced by the solar cell after deployment at the predetermined time in the specific earth orbit after deployment; simulating the effect of such radiation and temperature on a plurality of upper first, second and third solar subcell candidates for implementation by a computer program; and identifying the composition, thickness, and band gaps of at least the upper first, second and third subcells, and the location and band gap of the depletion layer within such subcells, and the doping within such subcells, that maximizes the collection probability and thereby the efficiency of the solar cell at that predetermined time.

In another aspect the present disclosure is directed to a multijunction solar cell with a specified composition, thickness, and band gaps of at least the upper first, second and third subcells, wherein the location and band gap of the depletion layer within such subcells, and the doping within such subcells, is aimed at maximizing the collection probability and thereby the efficiency of the solar cell at that predetermined end of life time.

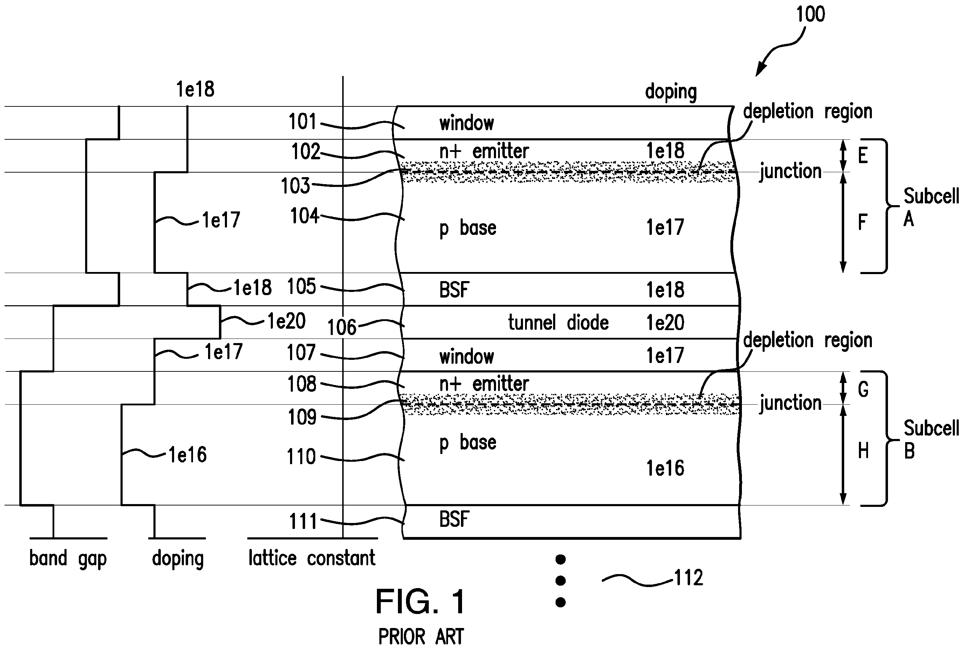

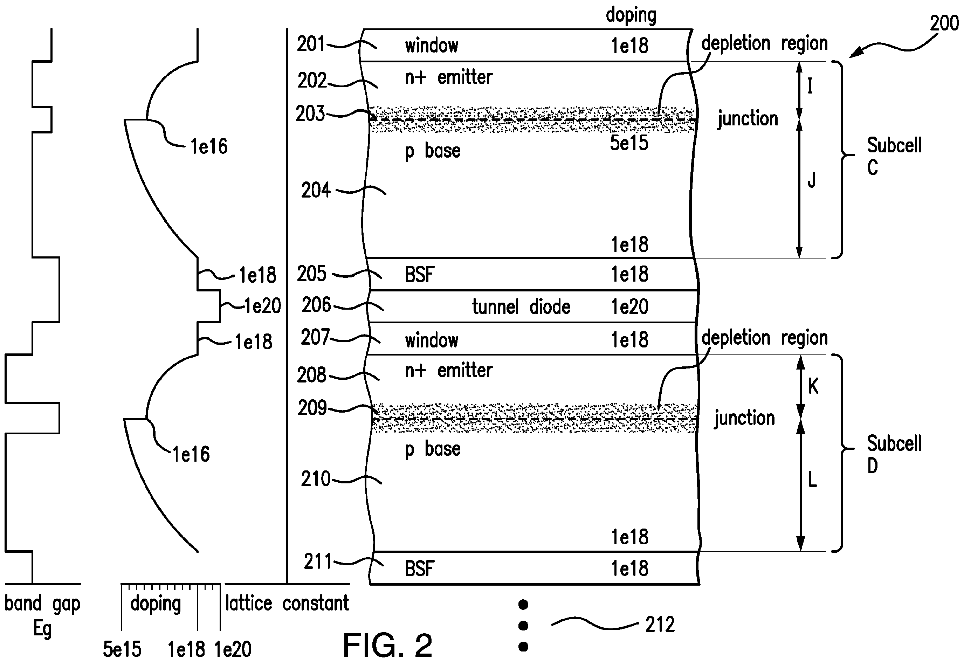

The following FIG 1 and 2 will illustrate at least the top two subcells of such a multijunction solar cell with FIG. 1 according to the prior art and FIG. 2 according to an example of the present disclosure.

FIG. 1 illustrates a particular example of an embodiment of a multijunction solar cell 100 after several stages of fabrication including the growth of certain semiconductor layers on the growth substrate (not shown) up to the top layer 101 of the semiconductor body as provided in the prior art.

As shown in the illustrated example of FIG. 1, the Figure depicts a portion of a solar cell 100 that includes a top subcell A that includes a window layer 101, a highly doped n-type emitter layer 102, typically (In)GaAs, and a p type base layer 104. A junction and depletion region 103 is disposed between the emitter layer 102 and base layer 104. A BSF ("Back Surface Field") layer 105 is disposed below the p base layer 105. The subcell B is disposed directly below subcell A and includes, for example, a highly doped n-type (In)GaAs emitter layer 107, an n+ type emitter layer 108, and a p type base layer 110 formed of p-type (In)GaAs. A junction and depletion region 109 is disposed between the emitter layer 108 and base layer 110. A BSF layer 111 is disposed below the p base layer 111.

The left hand side of the Figure depicts a first graph depicting the band gap of the layers of the solar cell 100, a second graph depicting the level of doping (measured in free carriers per cubic centimeter, ranging from 1 x 10¹⁶ to 1 x 10¹⁸) in each layer, and a third graph depicting the lattice constant (i.e. being approximately identical for each layer).

On the right hand side of the Figure, the thickness of the emitter layer 102 of subcell A is designated with letter E, and the thickness of the base layer 104 of subcell A is designated with letter F.

In a solar cell of the prior art, the ratio E:F may be in the range of 1:4 to 1:10, depending upon the configuration of the solar cell. A more common or typical range may be 1:8 for a triple junction solar cell.

On the right hand side of the Figure, the thickness of the emitter layer 108 of subcell B is designated with letter G, and the thickness of the base layer 110 of subcell B is designated with letter H.

In a solar cell of the prior art, the ratio G:H may be in the range of 1:15 to 1:40 depending upon the configuration of the solar cell. A more common or typical range may be 1:20.

FIG. 2 illustrates a particular example of an embodiment of a multijunction solar cell 200 after several stages of fabrication including the growth of certain semiconductor layers on the growth substrate (not shown) up to the top layer 101 of the semiconductor body according to the present disclosure.

As shown in the illustrated example of FIG. 2, the Figure depicts a portion of a solar cell 200 that includes a top subcell C that includes a window layer 201, a highly doped n-type emitter layer 202, typically (In)GaAs, and a p type base layer 204. A junction and depletion region 203 is disposed between the emitter layer 202 cand base layer 204. A BSF layer 205 is disposed below the p base layer 205. The subcell D is disposed directly below subcell C and includes, for example, a highly doped n-type (In)GaAs emitter layer 207, an n+ type emitter layer 208, and a p type base layer 210 formed of p-type (In)GaAs. A junction and depletion region 209 is disposed between the emitter layer 208 and base layer 210. A BSF layer 211 is disposed below the p base layer 211. Other layers 212 of the solar cell 200 are not depicted for simplicity in the drawing.

The left hand side of the Figure depicts a first graph depicting the band gap of the layers of the solar cell 200, a second graph depicting the level of doping (measured in free carriers per cubic centimeter, ranging from 5 x 10¹⁵ to 1 x 10²⁰) in each layer, and a third graph depicting the lattice constant (i.e. being approximately identical for each layer).

On the right hand side of the Figure, the thickness of the emitter layer 202 of subcell C is designated with letter I, and the thickness of the base layer 204 of subcell C is designated with letter J.

In a solar cell of the present disclosure, the ratio I:J may be in the range of 5:1 to 1:4. A more common or typical range may be 2:1 to 1:2.

On the right hand side of the Figure, the thickness of the emitter layer 208 of subcell D is designated with letter K, and the thickness of the base layer 210 of subcell D is designated with letter L.

In a solar cell of the prior art, the ratio K:L may be in the range of 1:2 to 1:5. A more common or typical range may be 1:3 to 1:4.

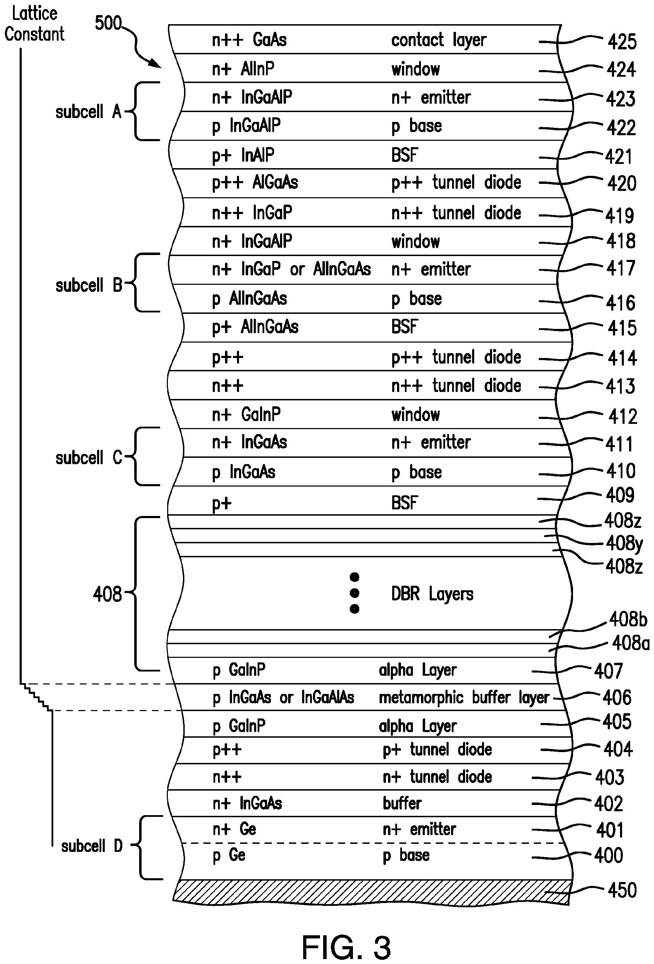

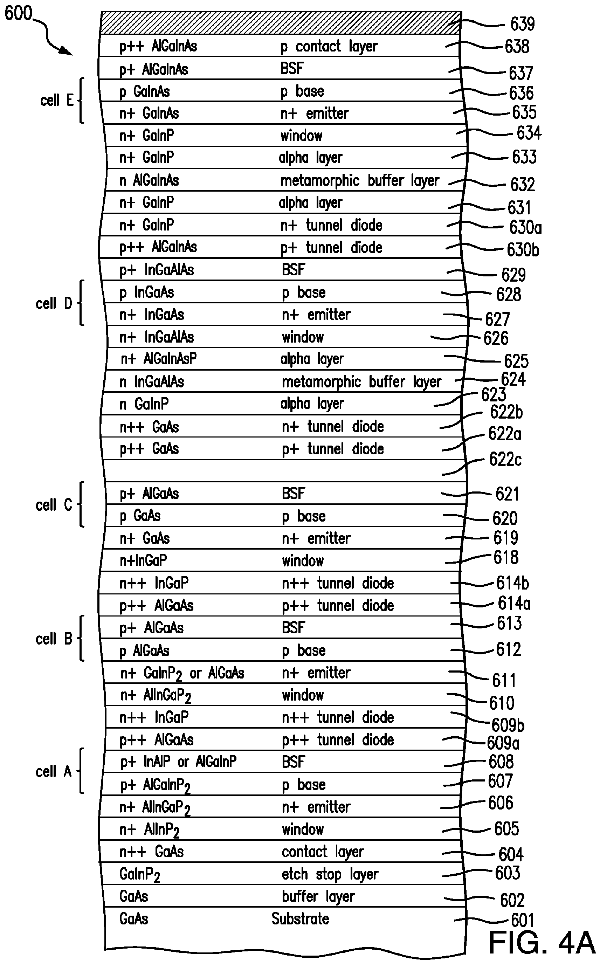

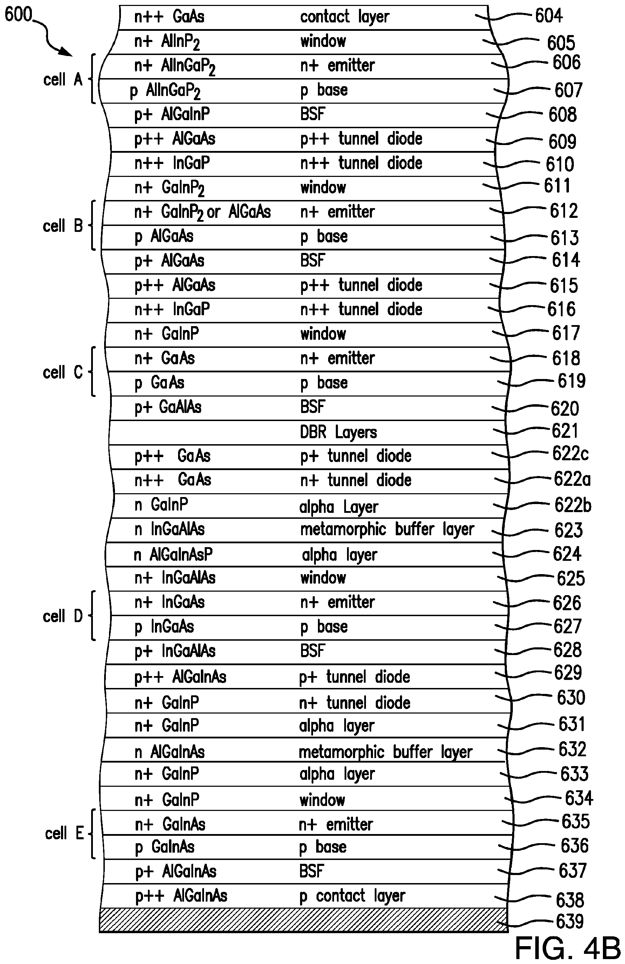

FIG. 3 and FIG. 4A and 4B depict more detailed structural views of upright and inverted metamorphic multijunction solar cells respectively such as originally described in U.S. Patent Application Serial Nos. 14/828,206 filed August 17, 2015, and published as US 2017/0054048 or Serial No. 14/828,197 filed August 17, 2015 and published as US 2015/0357501, or Serial No. 15/352,941 filed November 16, 2016 and published as US 2017/0062642 A1, to illustrate examples of multijunction solar cells in which the junction/depletion layer positioning according to the present disclosure may be implemented.

As shown in the illustrated example of FIG. 3, the upright multijunction solar cell 500 includes a growth substrate or bottom subcell D formed from a substrate 400 of p-type germanium ("Ge") which also serves as a base layer. A back metal contact pad 450 formed on the bottom of base layer 400 provides one electrical contact of a positive polarity to the multijunction solar cell 500. The bottom subcell D, further includes, for example, a highly doped n-type Ge emitter layer 401, and an n-type indium gallium arsenide ("InGaAs") nucleation layer 402. The nucleation layer is deposited over the base layer, and the emitter layer is formed in the substrate by diffusion of deposits into the Ge substrate, thereby forming the n-type Ge layer 401. Heavily doped p-type aluminum gallium arsenide ("AIGaAs") and heavily doped n-type gallium arsenide ("GaAs") tunneling junction layers 403, 404 may be deposited over the nucleation layer to provide a low resistance pathway between the bottom and middle subcells.

A first alpha layer 405, preferably composed of n-type InGaP or other suitable material, is deposited over the tunnel diode 403/404, to a thickness of between 0.25 and 1.0 micron. Such an alpha layer is intended to prevent threading dislocations from propagating, either opposite to the direction of growth into the bottom subcell D, or in the direction of growth into the subcell C, and is more particularly described in U.S. Patent Application Pub. No. 2009/0078309 A1 (Cornfeld et al.).

Figures 2 and 3 depict more detailed structural views of multijunction cells such as described in aforementioned U.S. Patent Application Serial Nos. 14/828,206 filed August 17, 2015, or Serial No. 14/828,197 filed August 17, 2015, or Serial No. 15/352,941 filed November 16, 2016, in which the junction/depletion layer positioning according to the present disclosure may be implemented.

As shown in the illustrated example of FIG. 3, the growth substrate or bottom subcell D includes a substrate 400 formed of p-type germanium ("Ge") which also serves as a base layer. A back metal contact pad 450 formed on the bottom of base layer 400 provides one electrical contact of a positive polarity to the multijunction solar cell 500. The bottom subcell D, further includes, for example, a highly doped n-type Ge emitter layer 401, and an n-type indium gallium arsenide ("InGaAs") nucleation layer 402. The nucleation layer is deposited over the base layer, and the emitter layer is formed in the substrate by diffusion of deposits into the Ge substrate, thereby forming the n-type Ge layer 401. Heavily doped p-type aluminum gallium arsenide ("AIGaAs") and heavily doped n-type gallium arsenide ("GaAs") tunneling junction layers 403, 404 may be deposited over the nucleation layer to provide a low resistance pathway between the bottom and middle subcells.

A first alpha layer 405, preferably composed of n-type InGaP or other suitable material, is deposited over the tunnel diode 403/404, to a thickness of between 0.25 and 1.0 micron. Such an alpha layer is intended to prevent threading dislocations from propagating, either opposite to the direction of growth into the bottom subcell D, or in the direction of growth into the subcell C, and is more particularly described in U.S. Patent Application Pub. No. 2009/0078309 A1 (Cornfeld et al.).

A metamorphic layer (or graded interlayer) 406 is deposited over the alpha layer 405 using a surfactant. Layer 406 is preferably a compositionally step-graded series of InGaAIAs layers, preferably with monotonically changing lattice constant, so as to achieve a gradual transition in lattice constant in the semiconductor structure from subcell D to subcell C while minimizing threading dislocations from occurring. The band gap of layer 406 is constant throughout its thickness, in the range of 1.22 to 1.54 eV, or otherwise consistent with a value slightly greater than the band gap of the middle subcell C. One embodiment of the graded interlayer may also be expressed as being composed of InxGa1-xAs, 0 < x < 1, 0 < y < 1, with x and y selected such that the band gap of the interlayer remains constant at approximately 1.22 to 1.54 eV or other appropriate band gap.

In the surfactant assisted growth of the metamorphic layer 406, a suitable chemical element is introduced into the reactor during the growth of layer 406 to improve the surface characteristics of the layer. In one embodiment, such element may be a dopant or donor atom such as selenium (Se) or tellurium (Te). Small amounts of Se or Te are therefore incorporated in the metamorphic layer 406, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may use an isoelectronic surfactant. The term "isoelectronic" refers to surfactants such as antimony (Sb) or bismuth (Bi), since such elements have the same number of valence electrons as the P atom of InGaP, or the As atom in InGaAIAs, in the metamorphic buffer layer. Such Sb or Bi surfactants will not typically be incorporated into the metamorphic layer 406.

In one embodiment of the present disclosure, the layer 406 is composed of a plurality of layers of InGaAs, with monotonically changing lattice constant, each layer having the same band gap, approximately in the range of 1.22 to 1.54 eV. In some embodiments, the constant band gap is in the range of 1.27 to 1.31 eV. In some embodiments, the constant band gap is in the range of 1.28 to 1.29 eV.

The advantage of utilizing a constant bandgap material such as InGaAs is that arsenide-based semiconductor material is much easier to process in standard commercial MOCVD reactors.

Although one embodiment of the present disclosure utilizes a plurality of layers of InGaAs for the metamorphic layer 406 for reasons of manufacturability and radiation transparency, other embodiments of the present disclosure may utilize different material systems to achieve a change in lattice constant from subcell C to subcell D. Other embodiments of the present disclosure may utilize continuously graded, as opposed to step graded, materials. More generally, the graded interlayer may be composed of any of the As, P, N, Sb based III - V compound semiconductors subject to the constraints of having the in-plane lattice parameter greater than or equal to that of the bottom solar cell and less than or equal to that of the third solar cell, and having a bandgap energy greater than that of the third solar cell.

A second alpha layer 407, preferably composed of n+ type InGaP with a different composition than the first alpha layer 405, is deposited over metamorphic buffer layer 406, to a thickness from 0.25 to 1.0 micron. Such an alpha layer is intended to prevent threading dislocations from propagating, either opposite to the direction of growth into the subcell D, or in the direction of growth into the subcell C, and is more particularly described in U.S. Patent Application Pub. No. 2009/0078309 A1 (Cornfeld et al.).

Distributed Bragg reflector (DBR) layers 408 are then grown adjacent to and between the second alpha layer 407 and the third solar subcell C. The DBR layers 408 are arranged so that light can enter and pass through the third solar subcell C and at least a portion of which can be reflected back into the third solar subcell C by the DBR layers 408. In the embodiment depicted in FIG. 3 the distributed Bragg reflector (DBR) layers 408 are specifically located between the third solar subcell C and alpha layers 407; in other embodiments, the distributed Bragg reflector (DBR) layers may be located above the tunnel diode layers, as depicted in FIG. 3.

For some embodiments, distributed Bragg reflector (DBR) layers 408 can be composed of a plurality of alternating layers 408a through 408z of lattice matched materials with discontinuities in their respective indices of refraction. For certain embodiments, the difference in refractive indices between alternating layers is maximized in order to minimize the number of periods required to achieve a given reflectivity, and the thickness and refractive index of each period determines the stop band and its limiting wavelength.

For some embodiments, distributed Bragg reflector (DBR) layers 408a through 408z includes a first DBR layer composed of a plurality of n type or p type AlₓGa₁₋ₓAs layers, and a second DBR layer disposed over the first DBR layer and composed of a plurality of n type or p type Al_{y}Ga_{1-y}As layers, where 0 < x < 1, 0 < y < 1, and y is greater than x.

In the illustrated example of FIG. 3, the subcell C includes a highly doped p-type aluminum gallium arsenide ("AIGaAs") back surface field ("BSF") layer 409, a p-type InGaAs base layer 410, a highly doped n-type indium gallium phosphide ("InGaP2") emitter layer 411 and a highly doped n-type indium aluminum phosphide ("AlInP2") window layer 412. The InGaAs base layer 410 of the subcell C can include, for example, approximately 1.5% In. Other compositions may be used as well. The base layer 410 is formed over the BSF layer 409 after the BSF layer is deposited over the DBR layers 408a through 408z.

The window layer 412 is deposited on the emitter layer 411 of the subcell C. The window layer 412 in the subcell C also helps reduce the recombination loss and improves passivation of the cell surface of the underlying junctions. Before depositing the layers of the subcell B, heavily doped n-type InGaP and p-type AIGaAs (or other suitable compositions) tunneling junction layers 413, 414 may be deposited over the subcell C.

The middle subcell B includes a highly doped p-type aluminum gallium arsenide ("AIGaAs") back surface field ("BSF") layer 415, a p-type AIGaAs base layer 416, a highly doped n-type indium gallium phosphide ("InGaP2") or AIGaAs layer 417 and a highly doped n-type indium gallium aluminum phosphide ("AIGaAIP") window layer 418. The InGaP emitter layer 417 of the subcell B can include, for example, approximately 50% In. Other compositions may be used as well.

Before depositing the layers of the top cell A, heavily doped n-type InGaP and p-type AIGaAs tunneling junction layers 419, 420 may be deposited over the subcell B.

In the illustrated example, the top subcell A includes a highly doped p-type indium aluminum phosphide ("InAlP") BSF layer 421, a p-type InGaAlP base layer 422, a highly doped n-type InGaAlP emitter layer 423 and a highly doped n-type InAlP2 window layer 424. The base layer 422 of the top subcell A is deposited over the BSF layer 421 after the BSF layer 421 is formed over the tunneling junction layers 419, 420 of the subcell B. The window layer 424 is deposited over the emitter layer 423 of the top subcell A after the emitter layer 423 is formed over the base layer 422.

A cap or contact layer 425 may be deposited and patterned into separate contact regions over the window layer 424 of the top subcell A. The cap or contact layer 425 serves as an electrical contact from the top subcell A to metal grid layer (not shown). The doped cap or contact layer 425 can be a semiconductor layer such as, for example, a GaAs or InGaAs layer.

After the cap or contact layer 425 is deposited, the grid lines (not shown) are formed via evaporation and lithographically patterned and deposited over the cap or contact layer 425.

FIG. 4A depicts the inverted metamorphic multijunction solar cell 600 according to another embodiment of the present disclosure after the sequential formation of the five subcells A, B, C, D and E on a GaAs growth substrate. More particularly, there is shown a growth substrate 601, which is preferably gallium arsenide (GaAs), but may also be germanium (Ge) or other suitable material. For GaAs, the substrate is preferably a 15° off-cut substrate, that is to say, its surface is orientated 15° off the (100) plane towards the (111)A plane, as more fully described in U.S. Patent Application Pub. No. 2009/0229662 A1 (Stan et al.), specifically in paragraphs 0054 - 0060 of this document.

In the case of a Ge substrate, a nucleation layer (not shown) is deposited directly on the substrate 601. On the substrate, or over the nucleation layer (in the case of a Ge substrate), a buffer layer 602 and an etch stop layer 603 are further deposited. In the case of GaAs substrate, the buffer layer 602 is preferably GaAs. In the case of Ge substrate, the buffer layer 602 is preferably InGaAs. A contact layer 604 of GaAs is then deposited on layer 603, and a window layer 605 of AllnP is deposited on the contact layer. The subcell A, consisting of an n+ emitter layer 606 and a p-type base layer 607, is then epitaxially deposited on the window layer 605. The subcell A is generally latticed matched to the growth substrate 601.

It should be noted that the multijunction solar cell structure could be formed by any suitable combination of group III to V elements listed in the periodic table subject to lattice constant and bandgap requirements, wherein the group III includes boron (B), aluminum (Al), gallium (Ga), indium (In), and thallium (T). The group IV includes carbon (C), silicon (Si), germanium (Ge), and tin (Sn). The group V includes nitrogen (N), phosphorous (P), arsenic (As), antimony (Sb), and bismuth (Bi).

In one embodiment, the emitter layer 606 is composed of InGa(Al)P₂ and the base layer 607 is composed of InGa(Al)P₂. The aluminum or Al term in parenthesis in the preceding formula means that Al is an optional constituent, and in this instance may be used in an amount ranging from 0% to 40%.

Subcell A will ultimately become the "top" subcell of the inverted metamorphic structure after completion of the process steps according to the present disclosure to be described hereinafter.

On top of the base layer 607 a back surface field ("BSF") layer 608 preferably p+ AlGaInP is deposited and used to reduce recombination loss.

The BSF layer 608 drives minority carriers from the region near the base/BSF interface surface to minimize the effect of recombination loss. In other words, a BSF layer 608 reduces recombination loss at the backside of the solar subcell A and thereby reduces the recombination in the base.

On top of the BSF layer 608 is deposited a sequence of heavily doped p-type and n-type layers 609a and 609b that forms a tunnel diode, i.e., an ohmic circuit element that connects subcell A to subcell B. Layer 609a is preferably composed of p++ AIGaAs, and layer 609b is preferably composed of n++ InGaP.

A window layer 610 is deposited on top of the tunnel diode layers 609a/609b, and is preferably n+ InGaP. The advantage of utilizing InGaP as the material constituent of the window layer 610 is that it has an index of refraction that closely matches the adjacent emitter layer 611, as more fully described in U.S. Patent Application Pub. No. 2009/0272430 A1 (Cornfeld et al.). The window layer 610 used in the subcell B also operates to reduce the interface recombination loss. It should be apparent to one skilled in the art, that additional layer(s) may be added or deleted in the cell structure without departing from the scope of the present disclosure.

On top of the window layer 610 the layers of subcell B are deposited: the n-type emitter layer 611 and the p-type base layer 612. These layers are preferably composed of InGaP and AlInGaAs respectively (for a Ge substrate or growth template), or InGaP and AIGaAs respectively (for a GaAs substrate), although any other suitable materials consistent with lattice constant and bandgap requirements may be used as well. Thus, subcell B may be composed of a GaAs, InGaP, AlGaInAs, AIGaAsSb, GaInAsP, or AlGaInAsP, emitter region and a GaAs, InGaP, AlGaInAs, AIGaAsSb, GaInAsP, or AlGaInAsP base region.

In previously disclosed implementations of an inverted metamorphic solar cell, the second subcell or subcell B or was a homostructure. In the present disclosure, similarly to the structure disclosed in U.S. Patent Application Pub. No. 2009/0078310 A1 (Stan et al.), the second subcell or subcell B becomes a heterostructure with an InGaP emitter and its window is converted from InAlP to AlInGaP. This modification reduces the refractive index discontinuity at the window/emitter interface of the second subcell, as more fully described in U.S. Patent Application Pub. No. 2009/0272430 A1 (Cornfeld et al.). Moreover, the window layer 610 is preferably is doped three times that of the emitter 611 to move the Fermi level up closer to the conduction band and therefore create band bending at the window/emitter interface which results in constraining the minority carriers to the emitter layer.

On top of the cell B is deposited a BSF layer 613 which performs the same function as the BSF layer 609. The p++/n++ tunnel diode layers 614a and 614b respectively are deposited over the BSF layer 613, similar to the layers 609a and 609b, forming an ohmic circuit element to connect subcell B to subcell C. The layer 114a is preferably composed of p++ AIGaAs, and layer 614b is preferably composed of n++ InGaP.

A window layer 618 preferably composed of n+ type GalnP is then deposited over the tunnel diode layer 614. This window layer operates to reduce the recombination loss in subcell "C". It should be apparent to one skilled in the art that additional layers may be added or deleted in the cell structure without departing from the scope of the present disclosure.

On top of the window layer 618, the layers of cell C are deposited: the n+ emitter layer 619, and the p-type base layer 620. These layers are preferably composed of n+ type GaAs and n+ type GaAs respectively, or n+ type InGaP and p type GaAs for a heterojunction subcell, although another suitable materials consistent with lattice constant and bandgap requirements may be used as well.

In some embodiments, subcell C may be (In)GaAs with a band gap between 1.40 eV and 1.42 eV. Grown in this manner, the cell has the same lattice constant as GaAs but has a low percentage of Indium 0% < In < 1% to slightly lower the band gap of the subcell without causing it to relax and create dislocations. In this case, the subcell remains lattice matched, albeit strained, and has a lower band gap than GaAs. This helps improve the subcell short circuit current slightly and improve the efficiency of the overall solar cell.

In some embodiments, the third subcell or subcell C may have quantum wells or quantum dots that effectively lower the band gap of the subcell to approximately 1.3 eV. All other band gap ranges of the other subcells described above remain the same. In such embodiment, the third subcell is still lattice matched to the GaAs substrate. Quantum wells are typically "strain balanced" by incorporating lower band gap or larger lattice constant InGaAs (e.g. a band gap of ∼1.3 eV) and higher band gap or smaller lattice constant GaAsP. The larger/smaller atomic lattices/layers of epitaxy balance the strain and keep the material lattice matched.

A BSF layer 621, preferably composed of InGaAIAs, is then deposited on top of the cell C, the BSF layer performing the same function as the BSF layers 608 and 613.

The p++/n++ tunnel diode layers 622a and 622b respectively are deposited over the BSF layer 621, similar to the layers 614a and 614b, forming an ohmic circuit element to connect subcell C to subcell D. The layer 622a is preferably composed of p++ GaAs, and layer 622b is preferably composed of n++ GaAs.

An alpha layer 623, preferably composed of n-type GalnP, is deposited over the tunnel diode 622a/622b, to a thickness of about 1.0 micron. Such an alpha layer is intended to prevent threading dislocations from propagating, either opposite to the direction of growth into the top and middle subcells A, B and C, or in the direction of growth into the subcell D, and is more particularly described in U.S. Patent Application Pub. No. 2009/0078309 A1 (Cornfeld et al.).

A metamorphic layer (or graded interlayer) 624 is deposited over the alpha layer 623 using a surfactant. Layer 624 is preferably a compositionally step-graded series of InGaAIAs layers, preferably with monotonically changing lattice constant, so as to achieve a gradual transition in lattice constant in the semiconductor structure from subcell C to subcell D while minimizing threading dislocations from occurring. The band gap of layer 624 is constant throughout its thickness, preferably approximately equal to 1.5 to 1.6 eV, or otherwise consistent with a value slightly greater than the band gap of the middle subcell C. One embodiment of the graded interlayer may also be expressed as being composed of (InₓGa₁₋ₓ)_{y} Al_{1-y}As, with x and y selected such that the band gap of the interlayer remains constant at approximately 1.5 to 1.6 eV or other appropriate band gap.

In the surfactant assisted growth of the metamorphic layer 624, a suitable chemical element is introduced into the reactor during the growth of layer 624 to improve the surface characteristics of the layer. In the preferred embodiment, such element may be a dopant or donor atom such as selenium (Se) or tellurium (Te). Small amounts of Se or Te are therefore incorporated in the metamorphic layer 124, and remain in the finished solar cell. Although Se or Te are the preferred n-type dopant atoms, other non-isoelectronic surfactants may be used as well.

Surfactant assisted growth results in a much smoother or planarized surface. Since the surface topography affects the bulk properties of the semiconductor material as it grows and the layer becomes thicker, the use of the surfactants minimizes threading dislocations in the active regions, and therefore improves overall solar cell efficiency.

As an alternative to the use of non-isoelectronic one may use an isoelectronic surfactant. The term "isoelectronic" refers to surfactants such as antimony (Sb) or bismuth (Bi), since such elements have the same number of valence electrons as the P atom of InGaP, or the As atom in InGaAIAs, in the metamorphic buffer layer. Such Sb or Bi surfactants will not typically be incorporated into the metamorphic layer 624.

In the inverted metamorphic structure described in M.W. Wanlass et al., Lattice Mismatched Approaches for High Performance, III-V Photovoltaic Energy Converters (Conference Proceedings of the 31st IEEE Photovoltaic Specialists Conference, Jan. 3-7, 2005, IEEE Press, 2005),cited above, the metamorphic layer consists of nine compositionally graded InGaP steps, with each step layer having a thickness of 0.25 micron. As a result, each layer of Wanlass et al. has a different bandgap. In one of the embodiments of the present disclosure, the layer 624 is composed of a plurality of layers of InGaAIAs, with monotonically changing lattice constant, each layer having the same band gap, approximately in the range of 1.5 to 1.6 eV.

The advantage of utilizing a constant bandgap material such as InGaAIAs is that arsenide-based semiconductor material is much easier to process in standard commercial MOCVD reactors, while the small amount of aluminum assures radiation transparency of the metamorphic layers.

Although the preferred embodiment of the present disclosure utilizes a plurality of layers of InGaAIAs for the metamorphic layer 624 for reasons of manufacturability and radiation transparency, other embodiments of the present disclosure may utilize different material systems to achieve a change in lattice constant from subcell C to subcell D. Thus, the system of Wanlass using compositionally graded InGaP is a second embodiment of the present disclosure. Other embodiments of the present disclosure may utilize continuously graded, as opposed to step graded, materials. More generally, the graded interlayer may be composed of any of the As, P, N, Sb based III - V compound semiconductors subject to the constraints of having the in-plane lattice parameter greater than or equal to that of the second solar cell and less than or equal to that of the third solar cell, and having a bandgap energy greater than that of the second solar cell.

An alpha layer 625, preferably composed of n+ type AlGaInAsP, is deposited over metamorphic buffer layer 624, to a thickness of about 1.0 micron. Such an alpha layer is intended to prevent threading dislocations from propagating, either opposite to the direction of growth into the top and middle subcells A, B and C, or in the direction of growth into the subcell D, and is more particularly described in U.S. Patent Application Pub. No. 2009/0078309 A1 (Cornfeld et al.).

A window layer 626 preferably composed of n+ type InGaAIAs is then deposited over alpha layer 625. This window layer operates to reduce the recombination loss in the fourth subcell "D". It should be apparent to one skilled in the art that additional layers may be added or deleted in the cell structure without departing from the scope of the present disclosure.

On top of the window layer 626, the layers of cell D are deposited: the n+ emitter layer 627, and the p-type base layer 628. These layers are preferably composed of n+ type InGaAs and p type InGaAs respectively, or n+ type InGaP and p type InGaAs for a heterojunction subcell, although another suitable materials consistent with lattice constant and bandgap requirements may be used as well.

A BSF layer 629, preferably composed of p+ type InGaAIAs, is then deposited on top of the cell D, the BSF layer performing the same function as the BSF layers 608, 613 and 621.

The p++/n++ tunnel diode layers 630a and 630b respectively are deposited over the BSF layer 629, similar to the layers 622a/622b and 609a/609b, forming an ohmic circuit element to connect subcell D to subcell E. The layer 630a is preferably composed of p++ AlGaInAs, and layer 630b is preferably composed of n++ GalnP.

In some embodiments an alpha layer 631, preferably composed of n-type GalnP, is deposited over the tunnel diode 630a/630b, to a thickness of about 0.5 micron. Such alpha layer is intended to prevent threading dislocations from propagating, either opposite to the direction of growth into the middle subcells C and D, or in the direction of growth into the subcell E, and is more particularly described in U.S. Patent Application Pub. No. 2009/0078309 A1 (Cornfeld et al.)..

A second metamorphic layer (or graded interlayer) 632 is deposited over the barrier layer 631. Layer 632 is preferably a compositionally step-graded series of AIGalnAs layers, preferably with monotonically changing lattice constant, so as to achieve a gradual transition in lattice constant in the semiconductor structure from subcell D to subcell E while minimizing threading dislocations from occurring. In some embodiments the band gap of layer 632 is constant throughout its thickness, preferably approximately equal to 1.1 eV, or otherwise consistent with a value slightly greater than the band gap of the middle subcell D. One embodiment of the graded interlayer may also be expressed as being composed of (InₓGa₁₋ₓ)_{y} Al_{1-y}As, with 0 < x < 1, 0 < y < 1, and x and y selected such that the band gap of the interlayer remains constant at approximately 1.1 eV or other appropriate band gap.

In one embodiment of the present disclosure, an optional second barrier layer 633 may be deposited over the AlGaInAs metamorphic layer 632. The second barrier layer 633 performs essentially the same function as the first barrier layer 631 of preventing threading dislocations from propagating. In one embodiment, barrier layer 633 has not the same composition than that of barrier layer 631, i.e. n+ type GalnP.

A window layer 634 preferably composed of n+ type GalnP is then deposited over the barrier layer 633. This window layer operates to reduce the recombination loss in the fifth subcell "E". It should be apparent to one skilled in the art that additional layers may be added or deleted in the cell structure without departing from the scope of the present invention.

On top of the window layer 634, the layers of cell E are deposited: the n+ emitter layer 635, and the p-type base layer 636. These layers are preferably composed of n+ type GalnAs and p type GalnAs respectively, although other suitable materials consistent with lattice constant and band gap requirements may be used as well.

A BSF layer 637, preferably composed of p+ type AIGalnAs, is then deposited on top of the cell E, the BSF layer performing the same function as the BSF layers 608, 613, 621, and 629.

Finally a high band gap contact layer 638, preferably composed of p++ type AlGaInAs, is deposited on the BSF layer 637.

The composition of this contact layer 638 located at the bottom (non-illuminated) side of the lowest band gap photovoltaic cell (i.e., subcell "E" in the depicted embodiment) in a multijunction photovoltaic cell, can be formulated to reduce absorption of the light that passes through the cell, so that (i) the backside ohmic metal contact layer below it (on the non-illuminated side) will also act as a mirror layer, and (ii) the contact layer doesn't have to be selectively etched off, to prevent absorption.

It should be apparent to one skilled in the art, that additional layer(s) may be added or deleted in the cell structure without departing from the scope of the present invention.

A metal contact layer 639 is deposited over the p semiconductor contact layer 638. The metal is the sequence of metal layers Ti/Au/Ag/Au in some embodiments.

The metal contact scheme chosen is one that has a planar interface with the semiconductor, after heat treatment to activate the ohmic contact. This is done so that (1) a dielectric layer separating the metal from the semiconductor doesn't have to be deposited and selectively etched in the metal contact areas; and (2) the contact layer is specularly reflective over the wavelength range of interest.

Optionally, an adhesive layer (e.g., Wafer Bond, manufactured by Brewer Science, Inc. of Rolla, MO) can be deposited over the metal layer 631, and a surrogate substrate can be attached. In some embodiments, the surrogate substrate may be sapphire. In other embodiments, the surrogate substrate may be GaAs, Ge or Si, or other suitable material. The surrogate substrate can be about 40 mils in thickness, and can be perforated with holes about 1 mm in diameter, spaced 4 mm apart, to aid in subsequent removal of the adhesive and the substrate. As an alternative to using an adhesive layer, a suitable substrate (e.g., GaAs) may be eutectically or permanently bonded to the metal layer 631.

Optionally, the original substrate can be removed by a sequence of lapping and/or etching steps in which the substrate 601, and the buffer layer 602 are removed. The choice of a particular etchant is growth substrate dependent.

Figure 4B is a cross-sectional view of an embodiment of a solar cell 600 of FIG. 4A, with the orientation with the metal contact layer 639 being at the bottom of the Figure and with the original substrate 601 having been removed. In addition, the etch stop layer 603 has been removed, for example, by using a HCl/H2O solution. Thus, the light-facing top subcell A is now at the top of the Figure.

It should be apparent to one skilled in the art, that additional layer(s) may be added or deleted in the cell structure without departing from the scope of the present disclosure. For example, one or more distributed Bragg reflector (DBR) layers can be added for various embodiments of the present invention.

It will be understood that each of the elements described above, or two or more together, also may find a useful application in other types of structures or constructions differing from the types of structures or constructions described above.

It will be understood that each of the elements described above, or two or more together, also may find a useful application in other types of structures or constructions differing from the types of structures or constructions described above.

The terms "substantially", "essentially", "approximately", "about", or any other similar expression relating to particular parametric numerical value are defined as being close to that value as understood by one of ordinary skill in the art in the context of that parameter, and in one non-limiting embodiment the term is defined to be within 10% of that value, in another embodiment within 5% of that value, in another embodiment within 1% of that value, and in another embodiment within 0.5% of that value.

The terminology used in this disclosure is for the purpose of describing specific identified embodiments only and is not intended to be limiting of different examples or embodiments.

The term "coupled" as used herein is defined as connected, although not necessarily directly or physically adjoining, and not necessarily structurally or mechanically. A device or structure that is "configured" in a certain way is arranged or configured in at least that described way, but may also be arranged or configured in ways that are not described or depicted.

It is to be noted that the terms "front", "back", "side", "top", "bottom", "over", "on", "above", "beneath", "below", "under", and the like in the description and the claims, if any, are used for descriptive purposes and not necessarily for describing permanent relative positions. It is understood that the terms so used are interchangeable under appropriate circumstances such that the embodiments of the disclosure described herein are, for example, capable of operation in other orientations than those illustrated or otherwise described herein. For example, if the assembly in the figures is inverted or turned over, elements of the assembly described as "below" or "beneath" other elements or features would then be oriented "above" the other elements or features. Thus, the exemplary term "below" can encompass both an orientation of above and below. The assembly may be otherwise oriented (rotated by a number of degrees through an axis).

In the drawings, the position, relative distance, lengths, widths, and thicknesses of supports, substrates, layers, regions, films, etc., may be exaggerated for presentation simplicity or clarity. Like reference numerals designate like elements throughout the specification. It will be understood that when an element such as an element layer, film, region, or feature is referred to as being "on" another element, it can be disposed directly on the other element or the presence of intervening elements may also be possible. In contrast, when an element is referred to as being disposed "directly on" another element, there are no intervening elements present.

Furthermore, those skilled in the art will recognize that boundaries and spacings between the above described units/operations are merely illustrative. The multiple units/operations may be combined into a single unit/operation, a single unit/operation may be distributed in additional units/operations, and units/operations may be operated at least partially overlapping in time. Moreover, alternative embodiments may include multiple instances of a particular unit/operation, and the order of operations may be altered in various other embodiments.

The terms "front side" and "backside" refer to the final arrangement of the panel, integrated cell structure or of the individual solar cells with respect to the illumination or incoming light incidence.

In the claims, the word 'comprising' or 'having' does not exclude the presence of other elements or steps than those listed in a claim. It is understood that the terms "comprise", "comprising", "includes", and "including" if used herein, specify the presence of stated components, elements, features, steps, or operations, components but do not preclude the presence or addition of one or more other components, elements, features, steps, or operations, or combinations and permutations thereof.

The terms "a" or "an", as used herein, are defined as one or more than one. Also, the use of introductory phrases such as "at least one" and "one or more" in the claims should be construed to imply that the introduction of another claim element by the indefinite articles "a" or "an" limits any particular claim containing such introduced claim element to disclosures containing only one such element, even when the claim includes the introductory phrases "one or more" or "at least one" and indefinite articles such as "a" or "an". The same holds true for the use of definite articles.

Unless stated otherwise, terms such as "first" and "second" are used to arbitrarily distinguish between the elements such terms describe. Thus, these terms are not necessarily intended to indicate temporal or other prioritization of such elements. The fact that certain measures are recited in mutually different claims does not indicate that a combination of these measures cannot be used to advantage. It will be understood that, although the terms "first", "second", etc. may be used herein to describe various elements, devices, components, regions, layers, areas, and/or sections, these elements, devices, components, regions, layers, areas, and/or sections should not be limited by these terms. These terms are only used to distinguish one device, element, component, region, layer, area, or section from another device, element, component, region, layer area or section. Thus, a first device, element, component, region, layer, area, or section discussed below could be termed a second device, element, component, region, layer, area or section without departing from the teachings of example embodiments.

The present disclosure can be embodied in various ways. To the extent a sequence of steps are described, the above described orders of the steps for the methods are only intended to be illustrative, and the steps of the methods of the present disclosure are not limited to the above specifically described orders unless otherwise specifically stated. Note that the embodiments of the present disclosure can be freely combined with each other without departing from the spirit and scope of the disclosure.

Although some specific embodiments of the present disclosure have been demonstrated in detail with examples, it should be understood by a person skilled in the art that the above examples are only intended to be illustrative but not to limit the scope and spirit of the present disclosure. The above embodiments can be modified without departing from the scope and spirit of the present disclosure which are to be defined by the attached claims. Accordingly, other implementations are within the scope of the claims.

Although described embodiments of the present disclosure utilizes a vertical stack of a certain illustrated number of subcells, various aspects and features of the present disclosure can apply to stacks with fewer or greater number of subcells, i.e. two junction cells, three junction cells, four, five, six, seven junction cells, etc.

In addition, although the disclosed embodiments are configured with top and bottom electrical contacts, the subcells may alternatively be contacted by means of metal contacts to laterally conductive semiconductor layers between the subcells. Such arrangements may be used to form 3-terminal, 4-terminal, and in general, n-terminal devices. The subcells can be interconnected in circuits using these additional terminals these additional terminals such that most of the available photogenerated current density in each subcell can be used effectively, leading to high efficiency for the multijunction cell, notwithstanding that the photogenerated current densities are typically different in the various subcells.

As noted above, the solar cell described in the present disclosure may utilize an arrangement of one or more, or all, homojunction cells or subcells, i.e., a cell or subcell in which the p-n junction is formed between a p-type semiconductor and an n-type semiconductor both of which have the same chemical composition and the same band gap, differing only in the dopant species and types, and one or more heterojunction cells or subcells. Subcell C, with p-type and n-type InGaAs is one example of a homojunction subcell.

In some cells, a thin so-called "intrinsic layer" may be placed between the emitter layer and base layer, with the same or different composition from either the emitter or the base layer. The intrinsic layer may function to suppress minority-carrier recombination in the space-charge region. Similarly, either the base layer or emitter layer may also be intrinsic or not-intentionally-doped ("NID") over part or all of its thickness.

The composition of the window or BSF layers may utilize other semiconductor compounds, subject to lattice constant and band gap requirements, and may include AlInP, AlAs, AIP, AlGaInP, AIGaAsP, AlGaInAs, AlGaInPAs, GaInP, GaINaS, GaInPAs, AlGaAs, AlInAs, AlInPAs, GaAsSb, GaAsSb, AlInSb, GaInSb, AlGaInSb, AlN, GaN, InN, GaInN, AlGaInN, GaInNAs, AlGaInNAs, ZnSSe, CdSSe, and similar materials, and still fall within the spirit of the present invention.

Thus, while the description of the semiconductor device described in the present disclosure has focused primarily on solar cells or photovoltaic devices, persons skilled in the art know that other optoelectronic devices, such as thermophotovoltaic (TPV) cells, photodetectors and light-emitting diodes (LEDs), are very similar in structure, physics, and materials to photovoltaic devices with some minor variations in doping and the minority carrier lifetime. For example, photodetectors can be the same materials and structures as the photovoltaic devices described above, but perhaps more lightly-doped for sensitivity rather than power production. On the other hand, LEDs can also be made with similar structures and materials, but perhaps more heavily-doped to shorten recombination time, thus radiative lifetime to produce light instead of power.

Therefore, this disclosure also applies to photodetectors and LEDs with structures, compositions of matter, articles of manufacture, and improvements as described above for photovoltaic cells.

Without further analysis, from the forgoing others can, by applying current knowledge, readily adapt the device of the disclosure for various applications. Such adaptions should and are intended to be comprehended within the meaning and range of equivalence of the following claims.

## Claims

1. A multijunction solar cell comprising:
an upper first solar subcell composed of InGaP and having an emitter layer of n+ conductivity type with a first band gap and a thickness in the range of 350 - 500 nm and a base layer of p conductivity type and a thickness in the range of 100 - 1000 nm; and
a second solar subcell disposed adjacent to and below the upper first solar subcell composed of (In)GaAs having an emitter layer of n+ conductivity type with a second band gap less than the first band gap and a thickness in the range of 350 to 500 nm and a base layer of p conductivity type and a thickness in the range of 100 - 2500 nm.

2. A multijunction solar cell as defined in claim 1, wherein the doping in the upper first solar subcell is graded in doping in the base layer that increases from 5 x 10¹⁵ free carriers per cubic centimeter adjacent the photoelectric junction to 1 x 10¹⁸ free carriers per cubic centimeter adjacent to an adjoining layer at the rear of the base layer, and in the emitter layer having a gradation in doping that decreases from approximately 1 x 10¹⁸ free carriers per cubic centimeter in the region immediately adjacent an adjoining layer at the top of the emitter layer to 1 x 10¹⁶ free carriers per cubic centimeter in the region adjacent to the photoelectric junction.

3. A multijunction solar cell as defined in any of the preceding claims, wherein in the upper first solar subcell the ratio of the thickness of the emitter layer to the thickness of the base layer is in the range of 5:1 to 1:4, and the upper first solar cell is between 0.3 and 0.8 microns in thickness, and the second solar subcell is between 1.5 and 3.0 microns in thickness.

4. A multijunction solar cell as defined in any of the preceding claims, wherein the second solar subcell is a heterojunction subcell with a (In)GaAs emitter layer and a InGaP base layer, and the ratio of the thickness of the emitter layer to the thickness of the base layer is in the range of 1:2 to 1:5.

5. A multijunction solar cell as defined in any of the preceding claims, further comprising a third solar subcell disposed adjacent to and below the second solar subcell having an emitter layer of n+ conductivity type with a third band gap less than the second band gap and a thickness in the range of 350 to 500 nm and a base layer of p conductivity type and a thickness in the range of 100 to 2500 nm.

6. A multijunction solar cell as defined in any of the preceding claims, wherein the band gap in the depletion region of the upper first solar subcell is greater than that of the band gap in the emitter layer and the base layer of said subcell.

7. A multijunction solar cell as defined in any of the preceding claims, wherein an upper first solar subcell has a first band gap in the range of 2.0 to 2.2 eV; and
the second solar subcell includes an emitter layer composed of indium gallium phosphide or aluminum indium gallium arsenide, and a base layer composed of aluminum indium gallium arsenide and having a second band gap in the range of approximately 1.55 to 1.8 eV and being lattice matched with the upper first solar subcell; wherein the emitter and base layers of the second solar subcell form a p-n junction.

8. A multijunction solar cell as defined in any of the preceding claims, wherein the solar cell is (i) an upright four junction solar cell and the average band gap of all four subcells is equal to or greater than 1.35 eV where the average band gap of the solar cell is the numerical average of the lowest band gap material used in each subcell; or (ii) an inverted metamorphic four or five junction solar cell, wherein the upper first solar subcell has a band gap in the range of 2.0 to 2.15, the second solar subcell has a band gap in the range of 1.65 to 1.73 eV, and the third solar subcell has a band gap in the range of 1.15 to 1.2 eV.

9. The multijunction solar cell as defined in claim 8, further comprising:
a distributed Bragg reflector (DBR) layer adjacent to and disposed between the third and the fourth solar subcells and arranged so that light can enter and pass through the third solar subcell and at least a portion of which can be reflected back into the third solar subcell by the DBR layer; and is composed of a plurality of alternating layers of lattice matched materials with discontinuities in their respective indices of refraction; and
wherein the difference in refractive indices between alternating layers is maximized in order to minimize the number of periods required to achieve a given reflectivity, and the thickness and refractive index of each period determines the stop band and its limiting wavelength.

10. The multijunction solar cell as defined in claim 8, wherein the DBR layer includes a first DBR layer composed of a plurality of p type In_{z}AlₓGa_{1-x-z}As layers, and a second DBR layer disposed over the first DBR layer and composed of a plurality of p type
In_{w}Al_{y}Ga_{1-y-w}As layers, where 0 < w < 1, 0 < x < 1, 0 <y < 1, 0 < z < 1 and y is greater than x.

11. The multijunction solar cell as defined in any of claims 8-10, wherein the fourth solar subcell is lattice mismatched with respect to the third solar subcell, and the top subcell is composed of a base layer of (InₓGa₁₋ₓ)_{1-y}Al_{y}P where x is 0.505, and y is 0.142, corresponding to a band gap of 2.10 eV, and an emitter layer of (InₓGa₁₋ₓ)_{1-y}Al_{y}P where x is 0.505, and y is 0.107, corresponding to a band gap of 2.05 eV.

12. The multijunction solar cell as defined in any of claims 8-11, further comprising a tunnel diode disposed over the fourth subcell, and intermediate layer disposed between the third subcell and the tunnel diode wherein the intermediate layer is compositionally graded to lattice match the third solar subcell on one side and the tunnel diode on the other side and is composed of any of the As, P, N, Sb based III-V compound semiconductors subject to the constraints of having the in-plane lattice parameter greater than or equal to that of the third solar subcell and different than that of the tunnel diode, and having a band gap energy greater than that of the fourth solar subcell.

13. The multijunction solar cell as defined in any of claims 8-12, further comprising an intermediate layer disposed between the third subcell and the fourth subcell wherein the intermediate layer is compositionally step-graded with between one and four steps to lattice match the fourth solar subcell on one side and composed of InₓGa₁₋ₓAs or (InₓGa₁₋ₓ)_{y}Al_{1-y}As with 0 < x < 1, 0 < y < 1, and x and y selected such that the band gap is in the range of 1.15 to 1.41 eV throughout its thickness, or a band gap in the range of 1.15 to 1.41 eV, or 1.2 to 1.35 eV, or 1.25 to 1.30 eV throughout its thickness.

14. The multijunction solar cell as defined in any of the preceding claims, wherein either (i) the emitter layer; or (ii) the base layer and emitter layer, of the upper first subcell have different lattice constants from the lattice constant of the second subcell.

15. A method of manufacturing a multijunction solar cell according to any of claims 1 - 14, the method comprising:
providing a semiconductor growth substrate; and
depositing a first sequence of layers of semiconductor material forming at least a first and a second solar subcell on the growth substrate..
